# EUROPEAN PATENT APPLICATION

(11) **EP 4 838 556 A1**
(43) Date of publication of application: **11.11.2026**
(21) Application number: 24916951.7
(22) Date of filing: 26.12.2024
(51) Int. Cl.: H01L 21/027, H01L 21/02

(54) **PROCESSING DEVICE AND PROCESSING METHOD**

(30) Priority: 09.01.2024 JP 2024001402
(71) Applicant: Tokyo Electron Limited, Tokyo 107-6325 (JP)
(72) Inventor: KOBAYASHI, Shinji, Koshi City, Kumamoto 861-1116 (JP)
(74) Representative: Manitz Finsterwald Patent- und Rechtsanwaltspartnerschaft mbB
(86) International application number: PCT/JP2024/046214
(87) International publication number: WO 2025/150449

(57) **Abstract**

A processing apparatus capable of smoothly removing or rendering harmless substances discharged from semiconductor manufacturing is provided. A PFAS detoxification system 10 is a processing apparatus processing a waste liquid discharged from a semiconductor manufacturing apparatus, and includes a polymer filter 301 separating the waste liquid into a polymer concentrate having a polymer at a concentration equal to or higher than a preset level, and a monomer concentrate having a monomer at a concentration equal to or higher than a predetermined level without having the polymer at the concentration equal to or higher than the preset level; and a low-molecular-weight component processing module including a monomer concentrator 11b, a circulation path 16, filters 39, 40a, and 40b, a first filtrate path 17a, a first reservoir 20xa, a second filtrate path 17b, a second reservoir 20xb, a third filtrate path 18, and the like. The low-molecular-weight component processing module performs a processing of increasing a concentration of PFAS, which is a low-molecular-weight component, on the monomer concentrate separated by the polymer filter 301.

## Description

### TECHNICAL FIELD

The present disclosure relates to a processing apparatus and a processing method.

### BACKGROUND

Patent document 1 describes a wastewater processing apparatus including a processing device configured to reduce the content ratio of an organic fluorine compound and the like, an anion exchange tower filled with an ion exchange material including an anion exchanger, and a decomposition device configured to decompose a regenerant that has circulated through the anion exchange tower.

### PRIOR ART DOCUMENT

Patent Document 1: Japanese Patent Laid-open Publication No. 2010-125352

### DISCLOSURE OF THE INVENTION

### PROBLEMS TO BE SOLVED BY THE INVENTION

Exemplary embodiments provide a processing apparatus and a processing method capable of smoothly removing or rendering harmless substances discharged from semiconductor manufacturing.

### MEANS FOR SOLVING THE PROBLEMS

In an exemplary embodiment, a processing apparatus that processes a waste liquid discharged from a semiconductor manufacturing apparatus includes a first filter and a low-molecular-weight component processing module. The first filter separates the waste liquid into a first solution including a high-molecular-weight component at a concentration equal to or higher than a preset level, and a second solution not including the high-molecular-weight component at the concentration equal to or higher than the preset level and including a low-molecular-weight component at a concentration equal to or higher than a preset level. The low-molecular-weight component processing module performs a processing of increasing the concentration of the low-molecular-weight component in the second solution separated by the first filter.

### EFFECT OF THE INVENTION

According to the exemplary embodiment, it is possible to smoothly remove or render harmless substances resulting from semiconductor manufacturing.

### BRIEF DESCRIPTION OF THE DRAWINGS

**FIG. 1** is a schematic diagram of a processing system according to a first exemplary embodiment.
**FIG. 2** is a configuration diagram of a PFAS detoxification system shown in **FIG. 1**.
**FIG. 3** is a diagram illustrating a processing in a monomer concentrator.
**FIG. 4** is a diagram illustrating a detoxification device.
**FIG. 5** is a diagram illustrating a misting process in the detoxification device.
**FIG. 6** is a diagram illustrating a circulation filtration mechanism according to a modification example.
**FIG. 7A** to **FIG. 7C** are diagrams illustrating the circulation filtration mechanism according to the modification example.
**FIG. 8A** to **FIG. 8C** are diagrams illustrating the circulation filtration mechanism according to the modification example.
**FIG. 9** is a schematic diagram of a processing system according to a second exemplary embodiment.
**FIG. 10** is a configuration diagram of a semiconductor manufacturing apparatus shown in **FIG. 9**.
**FIG. 11A** to **FIG. 11C** are diagrams illustrating an interface block.
**FIG. 12** is a diagram illustrating installation stands.
**FIG. 13A** and **FIG. 13B** are diagrams illustrating a vacuum-system module and an atmospheric-system module, respectively.
**FIG. 14** is a diagram illustrating respective transfer paths.
**FIG. 15A** and **FIG. 15B** are diagrams illustrating switching of exhaust lines.
**FIG. 16** is a diagram illustrating an exhaust line according to a modification example.

### DETAILED DESCRIPTION

Hereinafter, exemplary embodiments will be described in detail with reference to the accompanying drawings. In the following description, same parts or parts having same functions will be assigned same reference numerals, and redundant descriptions thereof will be omitted.

### [First exemplary embodiment]

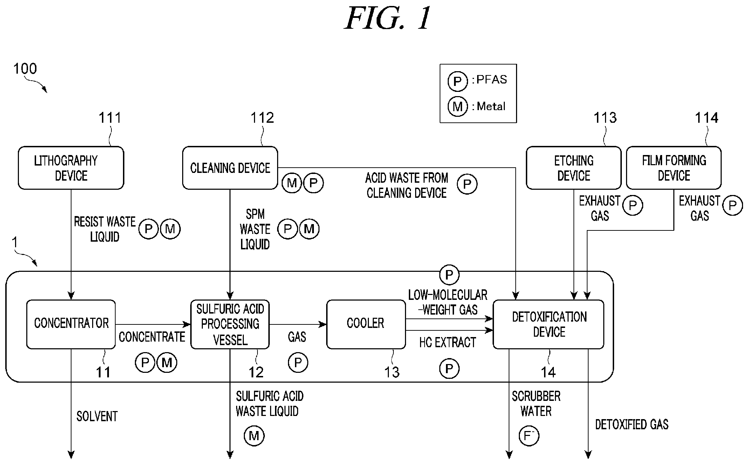

**FIG. 1** is a schematic diagram of a processing system 1 according to a first exemplary embodiment.

As illustrated in **FIG. 1**, the processing system 1 is equipped with a PFAS detoxification system 10 (processing apparatus) and a semiconductor manufacturing apparatus 100 (substrate processing apparatus). In the processing system 1, the PFAS detoxification system 10 detoxifies PFAS discharged from the semiconductor manufacturing apparatus 100. **FIG. 1** schematically shows the configuration of the PFAS detoxification system 10, and illustration of some components (for example, components related to a TMAH (tetramethylammonium hydroxide) waste liquid to be described later) is omitted. Here, PFAS refers to per- and polyfluoroalkyl substances, which are organic fluorine compounds.

PFAS refers to a compound containing one or more aliphatic molecules of -CF2- or -CF3, and also includes an organic polymer compound (polymer) such as Teflon. PFAS is included in, for example, a foam fire extinguisher, a plating liquid, an aircraft hydraulic fluid, a water repellent, a floor wax, and so forth. PFAS is also included in, for example, a textile, a medical product, an electronic substrate, an automobile, a food packaging paper, a stone material, flooring, a leather product, and so forth. In a semiconductor manufacturing process, non-polymeric PFAS, for example, is used in photoresist. Furthermore, polymeric PFAS is used in liquid-contact members such as a pipe, a valve, and a pump in a semiconductor manufacturing apparatus as well as in an antireflection film.

PFAS is stable in natural environment and difficult to decompose. For this reason, PFAS is said to have high persistence, to be readily accumulated in a living organism, and to be highly harmful. The PFAS detoxification system 10 according to the present exemplary embodiment is a system that detoxifies PFAS discharged from the semiconductor manufacturing apparatus 100, thereby suppressing the PFAS from being discharged to the outside. The PFAS detoxification system 10 functions as a processing apparatus configured to process a waste liquid discharged from the semiconductor manufacturing apparatus 100.

As shown in **FIG. 1**, the PFAS detoxification system 10 includes a concentrator 11, a sulfuric acid processing vessel 12, a cooler 13, and a detoxification device 14. Although the PFAS detoxification system 10 is described as being a group of devices including a plurality of devices in the present exemplary embodiment, the PFAS detoxification system 10 may be configured as a single device. The semiconductor manufacturing apparatus 100 includes a lithography device 111, a cleaning device 112, an etching device 113, and a film forming device 114. Each component of the semiconductor manufacturing apparatus 100 discharges a substance containing PFAS in association with a processing performed thereby. In addition, the respective processing devices constituting the PFAS detoxification system 10 may or may not be installed in the same space (location). For example, each processing device may be installed inside a building in which the lithography device 111, the cleaning device 112, or the etching device 113 is installed, or may be installed outside the building or in a space adjacent thereto. The respective processing devices may be separately installed inside and outside the building. In addition, any unused device among the concentrator 11, the sulfuric acid processing vessel 12, the cooler 13, and the detoxification device 14 need not be installed at all times.

The lithography device 111 includes a coating/developing device and an exposure device. The exposure device performs an exposure processing of a resist film. Specifically, an energy beam is applied to an exposure target portion of the resist film (photosensitive film) by a method such as immersion exposure. The coating/developing device performs a processing of forming a resist film on a surface of a substrate before the exposure processing by the exposure device, and performs a developing processing of the resist film after the exposure processing. A liquid or gas discharged from this lithography device 111 contains PFAS. By way of example, PFAS is contained in a resist waste liquid, an alkaline waste liquid (positive-type developing liquid) from the developing processing, an acid waste liquid from resist stripping, an organic exhaust gas, a thermal exhaust gas, a solidified sublimate, and the like. In addition, an organic solvent waste liquid generated by a negative-type developing processing can also be described as a very low-concentration resist waste liquid, which contains PFAS, and may be processed in the same way as the resist waste liquid described above in the present exemplary embodiment. In this exemplary embodiment, the PFAS contained in the resist waste liquid and the PFAS contained in the positive-type developing liquid are mainly described. Examples of the PFAS contained in the resist waste liquid include, by way of example, a photoacid generator (PAG), a surfactant, and an F-modified polymer. The resist waste liquid discharged from the lithography device 111 is introduced into the PFAS detoxification system 10.

The cleaning device 112 performs a cleaning processing on the substrate. For example, the cleaning device 112 uses SPM (Sulfuric Acid Hydrogen Peroxide Mixture), which is a mixture of H₂O₂ and sulfuric acid, to remove an organic substance such as resist. The cleaning device 112 uses a mixed aqueous solution (SC2: Standard Clean 2), which is a mixture of H₂O₂ and hydrochloric acid, to remove metal, and uses a mixed aqueous solution (SC1), which is a mixture of H₂O₂ and ammonia, to remove particles. Further, hot concentrated sulfuric acid alone is produced during the waste liquid processing. The cleaning device 112 discharges an SPM waste liquid containing PFAS. The SPM waste liquid and the hot concentrated sulfuric acid discharged from the cleaning device 112 are introduced into the sulfuric acid processing vessel 12. Additionally, the cleaning device 112 discharges an acid waste containing PFAS. The acid waste discharged from the cleaning device 112 is introduced into the detoxification device 14.

The etching device 113 performs an etching processing of etching an oxide film and a thin film according to a pattern of the formed resist film. The etching device 113 discharges an exhaust gas containing PFAS. The exhaust gas discharged from the etching device 113 is introduced into the detoxification device 14.

The film forming device 114 forms a wiring film and an insulating film on the substrate. The film forming device 114 uses various types of processing gases (gases containing or not containing PFAS), and discharges exhaust gases. The exhaust gases discharged from the film forming device 114 are introduced into the detoxification device 14.

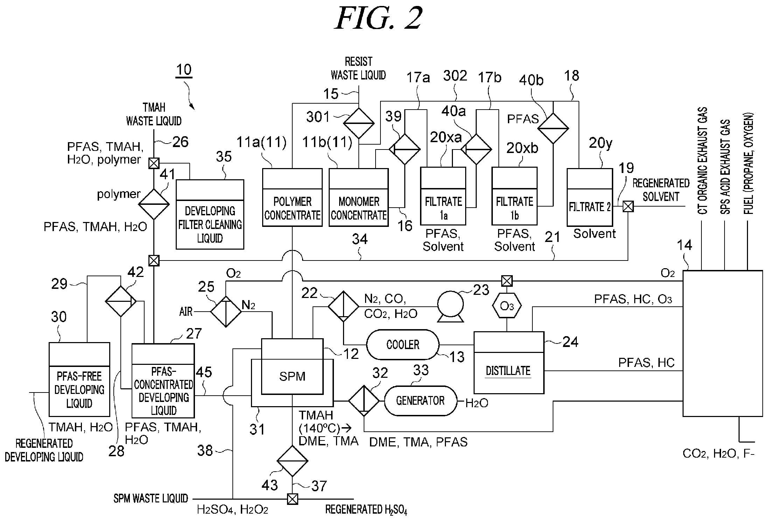

The concentrator 11 concentrates the PFAS-containing resist waste liquid discharged from the lithography device 111 of the semiconductor manufacturing apparatus 100. That is, the concentrator 11 concentrates a substrate processing waste liquid in the lithography device 111 as a waste liquid containing PFAS. Further, although the concentrator 11 has a polymer concentrator 11a and a monomer concentrator 11b (see **FIG. 2**) as will be described later, the polymer concentrator 11a and the monomer concentrator 11b will be herein described collectively as the concentrator 11 without distinction therebetween.. The concentrator 11 concentrates the resist waste liquid and separates a solvent contained in the resist waste liquid by using, for example, an ultrafiltration membrane or a reverse osmosis membrane (details will be described later). Since the concentrate of the resist waste liquid contains a polymer, it has a high viscosity. The concentrate of the resist waste liquid is introduced into the sulfuric acid processing vessel 12. In addition, when the alkaline waste liquid discharged from the lithography device 111 is concentrated by the concentrator 11, the alkaline waste liquid may be introduced into the reverse osmosis membrane after being neutralized.

The solvent separated from the resist waste liquid may be used as a regenerated solvent for cup cleaning or the like in the semiconductor manufacturing apparatus 100, or may be recovered by a solvent recovery contractor. Conventionally, when the solvent recovery contractor attempts to purify the regenerated solvent from the resist waste liquid, component analysis may result in recovery of a waste liquid containing a confidential material of a resist manufacturer. However, in the resist waste liquid passed through the concentrator 11 as in the present exemplary embodiment, a solid component is contained in the concentrate, so that leakage of confidential information to the solvent recovery contractor can be suppressed.

The sulfuric acid processing vessel 12 decomposes and volatilizes the concentrate concentrated by the concentrator 11 by using an SPM waste liquid. That is, the sulfuric acid processing vessel 12 utilizes the SPM waste liquid from the cleaning device 112. In the SPM waste liquid, the solvent and the polymer undergo a decomposition reaction such as an oxidation reaction or a dehydration reaction, resulting in lower molecular weight (lower viscosity). At this time, the temperature of the SPM waste liquid increases due to an exothermic reaction (that is, the temperature of the hot concentrated sulfuric acid in the SPM waste liquid rises). Basically, PFAS is not decomposed, but a component such as PAG volatilizes due to the high-temperature SPM waste liquid because it has a low boiling point (particularly, it volatilizes due to the effect of the hot concentrated sulfuric acid contained in the SPM waste liquid). Conventionally, a waste liquid processing of the SPM waste liquid has been performed by adding catalase in order to suppress foaming. However, when the component of H₂O₂ is completely consumed and degassed through a reaction with an organic substance in the sulfuric acid processing vessel 12, foaming does not occur in the sulfuric acid waste liquid on the downstream side, thereby facilitating the waste liquid processing. Further, the amount of the catalase can be reduced. Since this reaction generates heat of, *e.g.*, about 300°C, thermoelectric power generation using waste heat or steam power generation using steam generated from circulation water for cooling the sulfuric acid processing vessel 12 may be performed. Furthermore, the sulfuric acid waste liquid discharged from the sulfuric acid processing vessel 12 is recovered by, for example, a recycling contractor. The sulfuric acid waste liquid may have a higher purity of sulfuric acid than a conventional waste liquid. Further, it is desirable that the sulfuric acid processing vessel 12 be operated in a nitrogen atmosphere, which is an inert gas atmosphere, to suppress unintended ignition. Further, the SPM waste liquid may be a hot concentrated sulfuric acid waste liquid. In the case of hot concentrated sulfuric acid, the solvent and the polymer undergo a decomposition reaction such as a dehydration reaction, resulting in lower molecular weight (lower viscosity). At this time, the temperature of the hot concentrated sulfuric acid rises due to an exothermic reaction, causing the PFAS, the PAG, and the like to volatilize.

When the SPM waste liquid stored in the sulfuric acid processing vessel 12 is processed by adding the concentrate of the resist waste liquid thereto, H₂O₂ is gradually consumed, so that the processing capability decreases. After an appropriate amount of the concentrate of the resist waste liquid is supplied, the sulfuric acid processing vessel 12 is kept on standby until the reaction settles down and gas generation is stopped. Since a large amount of SPM waste liquid is discharged from the cleaning device 112, the SPM waste liquid from the cleaning device 112 also needs to be processed without delay. For this reason, the sulfuric acid processing vessel 12 may be configured with multiple processing vessels. In this case, while one processing vessel is performing a processing, preparation such as liquid injection may be performed in another processing vessel. Further, the liquid may be sent downstream in the order of a first processing vessel, a second processing vessel, and then a third processing vessel, while observing the progress of the reaction. Furthermore, when the resist waste liquid is a metal-containing resist, only a metal component does not volatilize but is precipitated in the same processes as described above, and is processed together with the sulfuric acid waste liquid.

Since the SPM waste liquid contains hydrogen peroxide water, if it is treated as a waste liquid without being processed, it may foam and put a burden on the device, or may deteriorate the environment as a foaming gas. In the configuration according to the present exemplary embodiment, however, the residual hydrogen peroxide water is effectively utilized, and the foaming gas is also burned as fuel in the detoxification device 14, thereby reducing the burden on the device and the environment.

The cooler 13 liquefies and collects the PFAS-containing gas volatilized by the sulfuric acid processing vessel 12. The cooler 13 separates the gas into a low-molecular-weight gas as a gaseous component and a hydrocarbon (HC) extract as a liquid component. As shown in **FIG. 2**, as the gas from the sulfuric acid processing vessel 12 is cooled in the cooler 13, the liquefied gas is collected as the HC extract, and the low-molecular-weight gas that has not been condensed is also collected. Since the gas generated from the sulfuric acid processing vessel 12 is processed in the nitrogen atmosphere, it becomes a mixed gas with nitrogen. For the mixed gas containing a large amount of nitrogen, a processing amount in the subsequent detoxification device 14 increases. Therefore, for example, the low-molecular-weight gas that has not been condensed in the cooler 13 may be separated into nitrogen and others by using a nano sub-ceramic filter to be concentrated.

Various types of organic gases and other gases are discharged from the sulfuric acid processing vessel 12 described above. PFAS such as PAG is also discharged as a gas. Although it may be considered to directly introduce these gases into the detoxification device 14, a gas that becomes a liquid at a room temperature may be first liquefied in the cooler 13, thereby improving transportability thereof. Further, when transported without being liquefied, liquid accumulation may occur in a pipeline, which may be difficult to control. PFAS is contained in both the liquefied HC extract and the low-molecular-weight gas that has not been condensed. The HC extract and the low-molecular-weight gas are introduced into the detoxification device 14. Additionally, to further improve the transportability of the gas, all the gases including the low-molecular-weight gas may be liquefied before being introduced into the detoxification device.

The detoxification device 14 detoxifies the material after being processed by the cooler 13. The detoxification device 14 may be a combustion abatement device that burns and abates the material after being processed by the cooler 13. The detoxification device 14 incinerates the HC extract and the low-molecular-weight gas introduced from the cooler 13. Since most of the HC extract is hydrocarbon, it can be burned as fuel. Also, since most of the low-molecular-weight gas is hydrocarbon having 10 or less carbon atoms, it can also be burned as fuel. Conventionally, a propane gas or city gas is used as fuel in conventional combustion abatement devices. In the present exemplary embodiment, since the HC extract or the like is used as fuel as described above, consumption of the propane gas and the like can be reduced.

In addition, the detoxification device 14 may simultaneously combust and abate the exhaust gas introduced from the etching device 113, the exhaust gas introduced from the film forming device 114, and the acid waste introduced from the cleaning device 112. These gases are exhaust gases containing PFAS used in the respective devices. By simultaneously combusting and abating these gases, the propane gas consumed can be further reduced. In addition, during the combustion and abatement, electric power generation may be performed by combusting the gases using an internal combustion engine such as a gas turbine. A detoxified gas such as carbon dioxide may be recovered to be used for the synthesis of an organic material such as formic acid or methanol. Furthermore, the detoxification device 14 may be a subcritical processing apparatus that performs a subcritical processing on the material processed by the cooler 13, or a supercritical processing apparatus that performs a supercritical processing on the material. Additionally, the detoxified waste gas may be treated into scrubber water containing F ions and an exhaust gas through a scrubber device (a device that washes the exhaust gas with water, neutralizes the exhaust gas with a chemical liquid, or adsorbs it, and releases it into the atmosphere). The scrubber water can be converted into calcium fluoride or fluorite by reaction with calcium. Fluorite is a starting material for a fluorine compound, which enables resource recycling.

Now, details of the PFAS detoxification system 10 shown in **FIG. 1** will be explained with reference to **FIG. 2** to **FIG. 5**. **FIG. 2** is a configuration diagram of the PFAS detoxification system 10 shown in **FIG. 1**. **FIG. 2** also illustrates configurations omitted in **FIG. 1** (such as a configuration related to a TMAH waste liquid, *etc.*). The PFAS detoxification system 10 further includes a waste liquid supply path 15, a polymer filter 301 (first filter), the polymer concentrator 11a, and the monomer concentrator 11b. The PFAS detoxification system 10 further includes a circulation path 16. The PFAS detoxification system 10 further includes a first filtrate path 17a, a second filtrate path 17b, a third filtrate path 18, a fourth filtrate path 19, a first reservoir 20xa, a second reservoir 20xb, and a third reservoir 20y. The PFAS detoxification system 10 also includes a bypass path 302. The PFAS detoxification system 10 additionally includes a first gas filter 22, a vacuum pump 23, and a distiller 24. The PFAS detoxification system 10 further includes a second gas filter 25. The PFAS detoxification system 10 also includes a waste liquid supply path 26, a concentrator 27, a circulation path 28, a developing liquid path 29, a regenerated developing liquid reservoir 30, a developing liquid processing vessel 31, a third gas filter 32, and a power generator 33. The PFAS detoxification system 10 further includes a backflow liquid reservoir 35. The PFAS detoxification system 10 further includes a discharge path 37. The PFAS detoxification system 10 is further equipped with an SPM supply path 38.

The PFAS-containing resist waste liquid discharged from the lithography device 111 flows through the waste liquid supply path 15 and is introduced into the polymer filter 301 provided in the waste liquid supply path 15. The polymer filter 301 separates the resist waste liquid into a polymer concentrate (first solution) having a polymer (high-molecular-weight component) at a concentration equal to or higher than a preset level, and a monomer concentrate (second solution) having a monomer (low-molecular-weight component) at a concentration equal to or higher than a predetermined level without having the polymer at the concentration equal to or higher than the preset level. The polymer concentrate may contain, *e.g.*, 20 weight% to 60 weight% of polymer. The monomer concentrate may contain, *e.g.*, 2 weight% to 30 weight% of monomer. The polymer filter 301 is a filter with coarser pores than a hollow fiber filter (filter 39, *etc.*) for extracting a filtrate (solvent) to be described later. The polymer concentrate separated by the polymer filter 301 is stored in the sulfuric acid processing vessel 12 via the polymer concentrator 11a. The monomer concentrate separated by the polymer filter 301 is stored in the monomer concentrator 11b. In this way, the monomer concentrator 11b serves as a storage that stores the monomer concentrate.

The circulation path 16 is a circulation flow path connected to the monomer concentrator 11b, and is provided with, at a portion thereof, a filter 39 for removing a polymer. The filter 39 is, for example, a hollow fiber filter. By providing the filter 39, the monomer concentrate is concentrated. The filtrate (solvent) that has passed through the filter 39 flows through the first filtrate path 17a and is stored in the first reservoir 20xa. Such filtrate is a low-concentration PFAS solution. The first reservoir 20xa is connected to the first filtrate path 17a and serves as a storage that stores the filtrate. The second filtrate path 17b is a flow path connecting the first reservoir 20xa to the second reservoir 20xb. The second filtrate path 17b is provided with a filter 40a. The filter 40a is, for example, an ion exchange resin filter. By providing the filter 40a, the filtrate passing through the filter 40a can be made into a solution having a low content of PFAS. The filtrate (solvent) having passed through the filter 40a flows through the second filtrate path 17b and is stored in the second reservoir 20xb. The second reservoir 20xb is a storage connected to the third filtrate path 18 and stores the filtrate. The third filtrate path 18 is a flow path connecting the second reservoir 20xb to the third reservoir 20y. The third filtrate path 18 is provided with a filter 40b. The filter 40b is, for example, an ion exchange resin filter. By providing the filter 40b, the filtrate passing through the filter 40b can be made into a solution containing almost no PFAS. The filtrate having passed through the filter 40b flows through the third filtrate path 18 and is stored in the third reservoir 20y. This filtrate can be used as a regeneration solvent, and flows outwards from the fourth filtrate path 19 located downstream of the third reservoir 20y.

For example, the filtrate may be introduced (made to be flow back) from an outlet side of the polymer filter 301 via the third filtrate path 18 and the bypass path 302. As a result, clogging caused by a polymer component and the like in the polymer filter 301 can be eliminated. Such backflow of the filtrate may be performed by, for example, gas pressurization or a liquid feeder such as a pump. Since the polymer solution has a high concentration and a high viscosity, a large amount of solvent is required to wash away the polymer solution. In addition, other methods require a process such as UV irradiation, oxidation by ozone, or plasma irradiation. In contrast, according to the method in which the filtrate is made to flow back, it is not necessary to prepare a separate solvent or perform UV irradiation and the like, thereby making it possible to clean the polymer filter 301 simply and appropriately.

The monomer concentrator 11b, the circulation path 16, the filters 39, 40a, and 40b, the first filtrate path 17a, the first reservoir 20xa, the second filtrate path 17b, the second reservoir 20xb, the third filtrate path 18, and the like constitute a low-molecular-weight component processing module. The low-molecular-weight component processing module performs a processing for increasing the concentration of PFAS, which is a low-molecular-weight component, on the monomer concentrate separated by the polymer filter 301. In particular, in the low-molecular-weight component processing module, the circulation path 16 and the filter 39 function as a circulation filtration mechanism that circulates the monomer concentrate to filter out the low-molecular-weight component. In addition, the filters 40a and 40b, the first filtrate path 17a, the first reservoir 20xa, the second filtrate path 17b, the second reservoir 20xb, the third filtrate path 18, and the like function as a purification mechanism for removing PFAS from the filtrate that has passed through the circulation filtration mechanism.

In addition, configurations downstream of the waste liquid supply path 15, such as the polymer filter 301 and the low-molecular-weight component processing module described above, may be separately provided for each type of the solvent contained in the waste liquid.

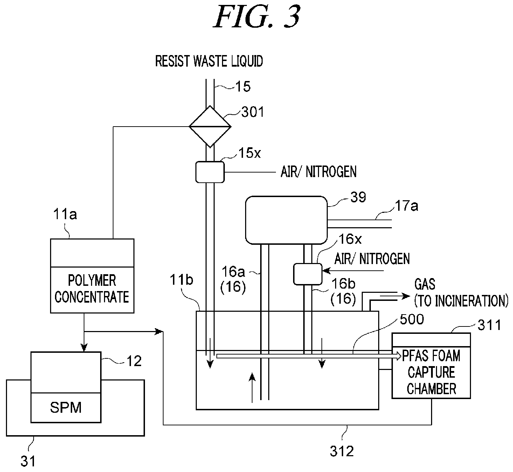

**FIG. 3** is a diagram illustrating a processing in the monomer concentrator 11b. As illustrated in **FIG. 3**, the PFAS detoxification system 10 further includes a PFAS foam capture chamber 311 (PFAS capture section). The PFAS foam capture chamber 311 is configured to capture PFAS foam collected in the monomer concentrator 11b. An inlet of the PFAS foam capture chamber 311 is located on the downstream side of a flow of the monomer concentrate along a liquid surface of the monomer concentrator 11b.

In the monomer concentrator 11b, microbubbles are generated by air or nitrogen in the monomer concentrate from which the polymer has been removed. Since PFAS gathers at an interface due to the microbubbles, it becomes possible to recover the high-concentration PFAS foam in a manner similar to skimming off a supernatant liquid. As illustrated in **FIG. 3**, a confluence portion 15x for adding air or nitrogen is provided in a portion of the waste liquid supply path 15, and the air or nitrogen is introduced into the monomer concentrator 11b together with the monomer concentrate. In the circulation path 16, an introduction path 16a for introducing the monomer concentrate into the filter 39 recovers the monomer concentrate from near a bottom surface of the monomer concentrator 11b (a deep portion away from a liquid surface). Further, in the circulation path 16, a discharge path 16b for returning the monomer concentrate from the filter 39 to the monomer concentrator 11b returns the monomer concentrate to the vicinity of the liquid surface of the monomer concentrator 11b. A confluence portion 16x for adding air or nitrogen is provided in a portion of the discharge path 16b. In this way, by sending the air or nitrogen toward the vicinity of the liquid surface in both the waste liquid supply path 15 and the discharge path 16b, microbubbles are generated near the liquid surface, thereby allowing the concentrated PFAS to gather at the interface. The waste liquid supply path 15 and the discharge path 16b function as a microbubble generator that generate the microbubbles in the monomer concentrate in the monomer concentrator 11b. Further, since the inlet of the PFAS foam capture chamber 311 is located at the downstream in the flow of the monomer concentrate along the liquid surface of the monomer concentrator 11b, the high-concentration PFAS foam can be recovered in the PFAS foam capture chamber 311 in a manner similar to skimming off a supernatant liquid at the interface.

Since the PFAS concentration decreases near the bottom surface of the monomer concentrator 11b, the PFAS concentration in the monomer concentrate recovered by the introduction path 16a and introduced into the filter 39 becomes lower. As a result, the recycling rate of the solvent can be increased.

The PFAS foam may be discharged through a flow path 312 into the sulfuric acid processing vessel 12 storing SPM and combusted therein, or may be evaporated by being heated before being discharged to the sulfuric acid processing vessel 12 so that a gas thereof is incinerated. Further, the PFAS foam may be processed together with a component that causes the PFAS component to be solidified. In addition, if PFAS remains in the sulfuric acid processing vessel 12 without being vaporized, it may be mixed into a waste liquid of residual sulfuric acid and become a contamination source. For this reason, the PFAS foam may be directly discharged into the detoxification device 14 (details of this will be described later). Further, the flow path of the PFAS foam may be periodically switched, and the PFAS foam may be discharged to the sulfuric acid processing vessel 12 depending on the amount of the SPM or the amount of the polymer concentrate in the sulfuric acid processing vessel 12.

Referring back to **FIG. 2**, the polymer concentrate is introduced into the sulfuric acid processing vessel 12 via the polymer concentrator 11a. In the sulfuric acid processing vessel 12, the polymer concentrate is decomposed and volatilized by the SPM waste liquid. As a result, a decomposition reaction such as a dehydration reaction or an oxidation reaction occurs, whereby the polymer concentrate is decomposed into a carbon monoxide, carbon dioxide, nitrogen, water vapor, a hydrocarbon-based gas, and a PFAS-containing gas. The gas discharged in this case has a temperature of 100°C or higher. The gas volatilized in the sulfuric acid processing vessel 12 is then separated by the first gas filter 22. The first gas filter 22 is a filter that separates the gas volatilized by the sulfuric acid processing vessel 12 into a PFAS-rich gas and a gas from which PFAS has been removed. The first gas filter 22 is, for example, a pervaporation filter, and may be a ceramic filter. The first gas filter 22 receives heat generated in the sulfuric acid processing vessel 12, and is therefore at a higher temperature than the concentrate before being decomposed. The first gas filter 22 may be disposed in the same space as the sulfuric acid processing vessel 12, or may receive heat generated in the sulfuric acid processing vessel 12 by being thermally connected to the sulfuric acid processing vessel 12 through a conductive member such as metal. Further, in the present exemplary embodiment, the PFAS-rich gas refers to a gas having a higher PFAS concentration than a gas before being affected by a preset action. Here, the separation by the first gas filter 22 corresponds to the preset action. Further, in the present exemplary embodiment, the preset action is not limited to the separation by the first gas filter 22, and when a PFAS-rich gas is generated, an action causing the generation of the PFAS-rich gas may be regarded as the preset action.

The first gas filter 22, which is a pervaporation filter, separates the gases by utilizing a difference in momentum resulting from a difference in molecular weight. Specifically, by reducing pressure on the downstream side, for example, the first gas filter 22 allows a gas having a relatively low molecular weight (such as nitrogen, carbon monoxide, carbon dioxide, and water vapor) to pass therethrough (flow to the downstream side), while suppressing a gas having a relatively high molecular weight (such as PFAS and hydrocarbon) from passing therethrough. As a result, the PFAS-rich gas and the gas from which PFAS has been removed can be substantially separated.

The vacuum pump 23 is a pump that reduces the pressure on the downstream side of the first gas filter 22, thereby enabling the separation of the gases by the first gas filter 22 described above. The cooler 13 liquefies and captures the PFAS-containing gas. The captured liquid and gas are stored in the distiller 24. The liquid PFAS and hydrocarbon, and the gaseous PFAS and hydrocarbon (and ozone to be described later) are introduced from the distiller 24 into the detoxification device 14.

In the PFAS detoxification system 10, exterior air (air) is introduced, and the exterior air is separated into nitrogen and oxygen by the second gas filter 25. Specifically, the second gas filter 25 separates the exterior air into a gas having a higher nitrogen concentration than air (hereinafter simply referred to as nitrogen) and a gas having a higher oxygen concentration than air (hereinafter simply referred to as oxygen). The second gas filter 25 supplies the nitrogen to the sulfuric acid processing vessel 12. This suppresses ignition in the sulfuric acid processing vessel 12. Further, the second gas filter 25 supplies the oxygen to the detoxification device 14. As a result, combustion in the detoxification device 14 can be promoted. Moreover, ozone generated from the above-described oxygen may be supplied to the detoxification device 14. The ozone may be supplied to the distiller 24 to be introduced into the detoxification device 14, or may be directly introduced into the detoxification device 14. The ozone may be generated from the oxygen by, for example, UV irradiation or electrical discharge.

In the PFAS detoxification system 10, the TMAH waste liquid, which is a positive-type developing liquid, is introduced from the lithography device 111. Then, in the PFAS detoxification system 10, the TMAH waste liquid discharged from the lithography device 111 of the semiconductor manufacturing apparatus 100 is concentrated in the concentrator 27. Further, the first concentrate, which is a concentrate of the positive-type developing liquid concentrated by the concentrator 27, is decomposed and volatilized in the developing liquid processing vessel 31.

The waste liquid supply path 26 is a supply path that supplies the TMAH waste liquid introduced from the lithography device 111 to the concentrator 27. This waste liquid supply path 26 and the waste liquid supply path 15 that supplies the resist waste liquid to the concentrator 11 are separately provided. The waste liquid supply path 26 is provided with a filter 41 for removing a polymer. That is, the filter 41 is a developing waste liquid filter configured to remove a polymer from the TMAH waste liquid. The circulation path 28 is connected to the concentrator 27, and is provided with a filter 42 for highly concentrating the PFAS. The developing liquid that has passed through the filter 42 (PFAS-free developing liquid) flows through the developing liquid path 29 and is stored in the regenerated developing liquid reservoir 30. This developing liquid can be used as a regenerated developing liquid. In this way, the filter 42 serves as a positive developing waste liquid processing module that separates the TMAH waste liquid into a PFAS-concentrated developing liquid and a PFAS-free developing liquid. The PFAS-free developing liquid may be made to flow back from the secondary side of the filter 41. The backflow liquid reservoir 35 is a cleaning liquid chamber for a developing liquid filter, which stores the liquid that has flown back and passed through the filter 41.

The concentrate concentrated in the concentrator 27 is supplied to the developing liquid processing vessel 31 via the concentrate path 45. The developing liquid processing vessel 31 is provided adjacent to the sulfuric acid processing vessel 12 described above. Specifically, the developing liquid processing vessel 31 is disposed so as to surround the sulfuric acid processing vessel 12 from below. With this configuration, the developing liquid processing vessel 31 receives heat from the sulfuric acid processing vessel 12, and the first concentrate can be decomposed and volatilized by the heat. The way to decompose the first concentrate is not limited to using heat, and by way of example, the first concentrate may be decomposed by being exposed to microorganisms. Further, the first concentrate may be used as a cooling solvent for the SPM in the sulfuric acid processing vessel 12.

TMAH decomposed by the heat (for example, heat of about 140°C) in the developing liquid processing vessel 31 is decomposed into trimethylamine and dimethyl ether. These gases can be used as fuel in the detoxification device 14. PFAS is not decomposed even by the heat, and is released as a gas and combusted in the detoxification device 14. The gases discharged from the developing liquid processing vessel 31 include nitrogen, water vapor, hydrocarbon, trimethylamine, dimethyl ether, PFAS, and the like. By, for example, reducing pressure on the downstream side, the third gas filter 32 allows a gas having a relatively low molecular weight (such as nitrogen and water vapor) to pass therethrough (flow to the downstream side), while suppressing a gas having a relatively high molecular weight (such as trimethylamine, dimethyl ether, PFAS, and hydrocarbon) from passing therethrough. As a result, a PFAS-rich gas and a gas from which PFAS has been removed can be substantially separated. The nitrogen, the water vapor, and the like are discharged out of the system. Further, power generation can be carried out using a pressure difference by returning the released water vapor to water in the generator 33. The PFAS-containing gas and the like to be sent to the detoxification device 14 may be compressed before being sent to the detoxification device 14.

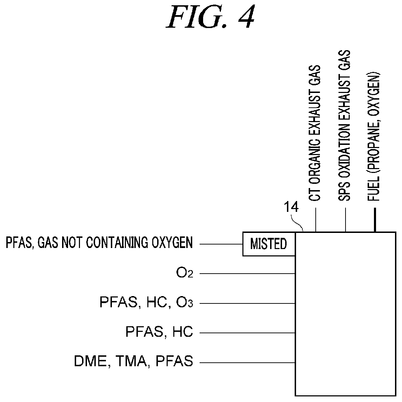

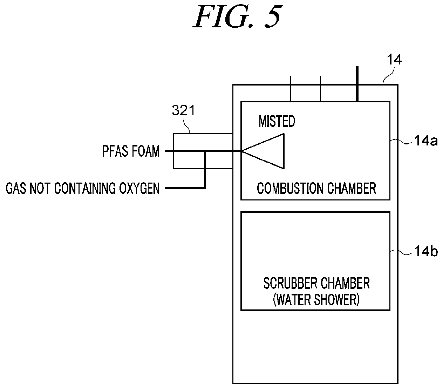

The detoxification device 14 may include a combustion chamber configured to combust a mixture of the gas volatilized by the developing liquid processing vessel 31 and the gas volatilized by the sulfuric acid processing vessel 12. As described above, PFAS foam may be misted and introduced into the detoxification device 14 (see **FIG. 4** and **FIG. 5**). In this case, as illustrated in **FIG. 4** and **FIG. 5**, the PFAS foam is introduced into the detoxification device 14 together with an oxygen-free gas that does not contain oxygen. This oxygen-free gas may include various kinds of gases generated in the PFAS detoxification system 10.

As shown in **FIG. 5**, specifically, the PFAS foam and the oxygen-free gas are misted and introduced into a combustion chamber 14a of the detoxification device 14. By misting the PFAS foam, the PFAS foam can be combusted at once. The organic gas is combusted into CO₂ or H₂O. In the PFAS gas, the bond between C and F is broken, and C is exhausted as CO₂ and F as F ions (fluoride ions). Then, in a scrubber chamber 14b of the detoxification device 14, the F ions are dissolved in water and recovered as HF (hydrofluoric acid). Afterwards, they are neutralized with, for example, sodium hydroxide and discharged as a waste liquid.

When the reaction between the resist concentrate and the SPM waste liquid proceeds in the sulfuric acid processing vessel 12, hydrogen peroxide in the SPM is deactivated, so that reaction capability significantly decreases. At this time, the SPM becomes concentrated sulfuric acid and can cause a dehydration reaction, but carbonization of an organic substance proceeds, causing the liquid to turn yellow or brown. Therefore, at the moment the liquid becomes yellow, for example, the SPM waste liquid is discharged from the discharge path 37. At this time, carbonized substances are filtered by a filter 43 provided in the discharge path 37. Since hydrogen peroxide is removed from the discharged SPM waste liquid and the purity of the sulfuric acid is increased through the filtering with the filter 43, so the discharged SPM waste liquid can be used as regenerated sulfuric acid.

When a new SPM waste liquid is supplied to the sulfuric acid processing vessel 12, the filter 43 trapping the carbonized substances can be cleaned by introducing a part of the SPM waste liquid from an outlet side of the filter 43. Specifically, by allowing the SPM waste liquid to flow through a flow path connected to the outlet of the filter 43 in the SPM supply path 38 for supplying the new SPM waste liquid to the sulfuric acid processing vessel 12, the SPM waste liquid may be made to react with the carbonized substances trapped in the filter 43. As a result, the carbonized substances trapped in the filter 43 become carbon dioxide and are exhausted, and the filter 43 is cleaned.

Now, operations and effects of the PFAS detoxification system 10 according to the present exemplary embodiment will be explained.

The PFAS detoxification system 10 according to the present exemplary embodiment is a processing apparatus configured to process a waste liquid discharged from the semiconductor manufacturing apparatus 100, and is equipped with the polymer filter 301 and the low-molecular-weight component processing module. The polymer filter 301 is a filter configured to separate the resist waste liquid into the polymer concentrate having a polymer at a concentration equal to or higher a preset level and the monomer concentrate having a monomer at a concentration equal to or higher than a predetermined level without having a polymer at a concentration equal to or higher than a preset level. The low-molecular-weight component processing module is composed of the monomer concentrator 11b, the circulation path 16, the filters 39, 40a, and 40b, the first filtrate path 17a, the first reservoir 20xa, the second filtrate path 17b, the second reservoir 20xb, the third filtrate path 18, and the like. The low-molecular-weight component processing module performs a process for increasing the concentration of PFAS, which is a low-molecular-weight component, on the monomer concentrate separated by the polymer filter 301.

In this way, after the polymer and the monomer are separated by the polymer filter 301, the process for increasing the PFAS concentration (that is, a process for removing PFAS) is performed on the monomer concentrate and the like. As a result, a component to be removed and detoxified can be processed more smoothly. As described above, in the PFAS detoxification system 10 according to the present exemplary embodiment, substances discharged from the semiconductor manufacturing process can be removed or made harmless smoothly.

The low-molecular-weight component processing module may have the circulation filtration mechanism that filters the low-molecular-weight component by circulating the monomer concentrate, and the purification mechanism that removes PFAS from the filtrate that has passed through the circulation filtration mechanism. According to this configuration, PFAS can be efficiently removed, so that the substances discharged from the semiconductor manufacturing process can be removed or made harmless more smoothly.

The aforementioned polymer filter 301 and the low-molecular-weight component processing module may be individually provided for respective types of the solvents included in the waste liquid. With this configuration, the removal of PFAS and the like can be appropriately performed for each of the various types of solvents.

The PFAS detoxification system 10 may be further equipped with the filter 42 that separates the TMAH waste liquid into the PFAS-concentrated developing liquid and the PFAS-free developing liquid, and the filter 41 that removes the polymer from the TMAH waste liquid. Additionally, the PFAS detoxification system 10 may be equipped with the backflow liquid reservoir 35 that stores the liquid obtained by allowing the PFAS-free developing liquid to flow back from the secondary side of the filter 41 and pass through the filter 41. With this configuration, PFAS can be appropriately removed from the TMAH waste liquid, and the filter 41 can be appropriately cleaned by the liquid that has flown back.

The molecular-weight component processing module may further include the monomer concentrator 11b storing the monomer concentrate, and the PFAS foam capture chamber 311 whose inlet is located on the downstream side of the flow of the monomer concentrate along the liquid surface of the monomer concentrator 11b. With this configuration, the PFAS collected along the flow of the monomer concentrate can be appropriately recovered.

The low-molecular-weight component processing module may further include the microbubble generator that generates microbubbles in the monomer concentrate of the monomer concentrator 11b. With this configuration, by generating the microbubbles, the concentrated PFAS is collected at an interface, and the PFAS can be appropriately recovered by the PFAS foam capture chamber 311 described above.

Although the exemplary embodiment has been described so far, the present disclosure is not limited thereto. By way of example, the one filter 39 provided in the circulation path 16 has been described as the circulation filtration mechanism, but the circulation filtration mechanism is not limited thereto. The circulation filtration mechanism may have a plurality of (*e.g.*, four) filters 39a, 39b, 39c, and 39d (second filters), and a passage order switching mechanism configured to switch the order of serial passage of the monomer concentrate through the plurality of filters 39a, 39b, 39c, and 39d.

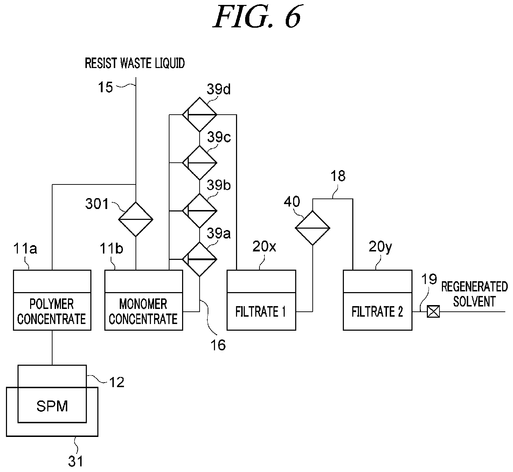

**FIG. 6** to **FIG. 8C** are drawings illustrating a circulation filtration mechanism according to a modification example. As shown in **FIG. 6**, the plurality of filters 39a, 39b, 39c, and 39d provided in the circulation path 16, which is a path connected to the monomer concentrator 11b, are connected with each other in series. Here, assuming that the monomer concentrate always flows in the order of the filter 39a, the filter 39b, the filter 39c, and the filter 39d, the filter 39a is contaminated most. As a way to uniformize the contamination of the filters, the aforementioned passage order switching mechanism is employed.

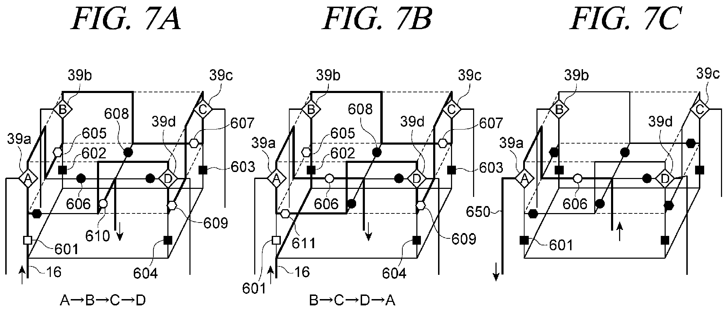

In **FIG. 7A** to **FIG. 7C**, the filter 39a is denoted by "A", the filter 39b by "B", the filter 39c by "C", and the filter 39d by "D". Additionally, flow paths and valves between the respective filters are schematically illustrated. Here, a description will be given for an example in which the order of the serial passage of the monomer concentrate through the respective filters is switched by controlling opening/closing operations of the valves. Therefore, each valve corresponds to the aforementioned passage order switching mechanism. Furthermore, although the four filters are arranged in series in the figures, the present disclosure is not limited thereto, and two or more filters may be arranged in series.

In an example shown in **FIG. 7A**, the valves are controlled so that the monomer concentrate passes in the order of "A → B → C → D". That is, a valve 601 of the flow path directed toward "A" is opened so that the monomer concentrate flowing through the circulation path 16 flows toward "A". Further, a valve 602 of the flow path directed toward "B," a valve 603 of the flow path directed toward "C," and a valve 604 of the flow path directed toward "D" are all closed so that the monomer concentrate flowing through the circulation path 16 does not initially flow toward "B", "C", and "D". Subsequently, a valve 605 of the flow path between "A" and "B" is opened so that the monomer concentrate flows from "A" to "B". Furthermore, a valve 606 of the flow path between "A" and "C" and between "A" and "D" is closed. Then, a valve 607 of the flow path between "B" and "C" is opened so that the monomer concentrate flows from "B" to "C". Additionally, a valve 608 of the flow path between "B" and "D" is closed. Subsequently, a valve 609 of the flow path between "C" and "D" and a valve 610 of the flow path between "D" and the reservoir of the filtrate are opened so that the monomer concentrate flows from "C" to "D" and then from "D" toward the reservoir of the filtrate.

In addition, in an example shown in **FIG. 7B**, the valves are controlled so that the monomer concentrate passes in the order of "B → C → D → A". That is, the valve 602 is opened so that the monomer concentrate flowing through the circulation path 16 flows toward "B". Further, the valve 601 of the flow path directed toward "A", the valve 603 of the flow path directed toward "C", and the valve 604 of the flow path directed toward "D" are all closed so that the monomer concentrate flowing through the circulation path 16 does not initially flow toward "A", "C", and "D". Subsequently, the valve 607 of the flow path between "B" and "C" is opened so that the monomer concentrate flows from "B" to "C". In addition, the valve 605 of the flow path between "B" and "A" and the valve 608 of the flow path between "B" and "D" are closed. Furthermore, the valve 609 of the flow path between "C" and "D" is opened so that the monomer concentrate flows from "C" to "D". Subsequently, a valve 611 of the flow path between "D" and "A" and the valve 606 of the flow path between "A" and the reservoir of the filtrate are opened so that the monomer concentrate flows from "D" to "A" and then from "A" toward the reservoir of the filtrate.

Additionally, before selecting the option of replacing the filter, a filtrate (thinner) may be made to flow back through the filter, thereby removing clogging (impurities) in the filter. In this case, cleaning of one filter among the plurality of filters may be enhanced. Such filter cleaning may be performed sequentially after a certain amount of processing is carried out. In an example shown in **FIG. 7C**, for the purpose of cleaning "A" (filter 39a), only the valve 606 of the flow path between the reservoir of the filtrate and "A" is opened so that the filtrate flows toward "A". Additionally, the valve 601 is closed so that the filtrate flows from "A" to a drain path 650.

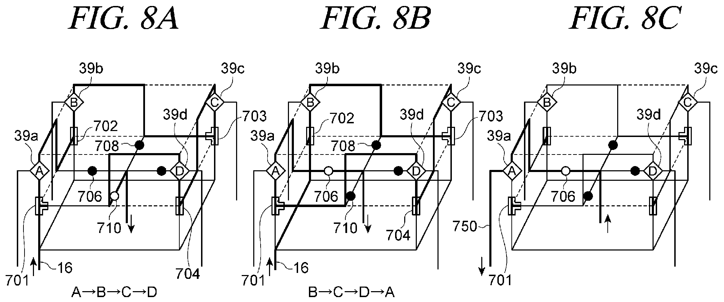

Instead of the valves described above, the order of passage may be switched by three-way valves. In **FIG. 8A** to **FIG. 8C**, the filter 39a is denoted by "A", the filter 39b by "B", the filter 39c by "C", and the filter 39d by "D". Additionally, the flow paths and the three-way valves between the respective filters are schematically illustrated. Here, a description will be provided for an example in which the order of the serial passage of the monomer concentrate through the respective filters is switched by controlling the three-way valves. Therefore, each three-way valve corresponds to the aforementioned passage order switching mechanism.

In an example shown in **FIG. 8A**, the three-way valves are controlled so that the monomer concentrate passes in the order of "A → B → C → D". That is, a three-way valve 701 of the flow path directed toward "A" is controlled so that the monomer concentrate flowing through the circulation path 16 flows toward "A". Further, a three-way valve 702 of the flow path directed toward "B", a three-way valve 703 of the flow path directed toward the "C", and a three-way valve 704 of the flow path directed toward "D" are controlled so that the monomer concentrate flowing through the circulation path 16 does not initially flow toward "B", "C", and "D". Subsequently, the three-way valve 702 of the flow path between "A" and "B" is controlled so that the monomer concentrate flows from "A" to "B". Further, a valve 706 of the flow path between "A" and "C" and between "A" and "D" is closed so that the monomer concentrate does not flow toward "C" and "D". Then, the three-way valve 703 of the flow path between "B" and "C" is controlled so that the monomer concentrate flows from "B" to "C". Also, a valve 708 of the flow path between "B" and "D" is closed. Subsequently, the three-way valve 704 of the flow path between "C" and "D" is controlled and a valve 710 of the flow path between "D" and the reservoir of the filtrate is opened so that the monomer concentrate flows from "C" toward "D" and then from "D" toward the reservoir of the filtrate.

In addition, in an example shown in **FIG. 8B**, the valves are controlled so that the monomer concentrate passes in the order of "B → C → D → A". That is, the three-way valve 702 of the flow path directed toward "B" is controlled so that the monomer concentrate flowing through the circulation path 16 flows toward "B". Further, the three-way valve 701 of the flow path directed toward "A", the three-way valve 703 of the flow path directed toward "C", and the three-way valve 704 of the flow path directed toward "D" are controlled so that the monomer concentrate flowing through the circulation path 16 does not initially flow toward "A", "C", and "D". Subsequently, the three-way valve 703 of the flow path between "B" and "C" is controlled so that the monomer concentrate flows from "B" to "C". Additionally, the valve 708 of the flow path between "B" and "D" is closed. Then, the three-way valve 704 of the flow path between "C" and "D" is controlled so that the monomer concentrate flows from "C" to "D". Subsequently, the three-way valve 701 of the flow path between "D" and "A" is controlled and the valve 706 of the flow path between "A" and the reservoir of the filtrate is opened so that the monomer concentrate flows from "D" to "A" and then from "A" toward the reservoir of the filtrate.

In addition, prior to selecting the option of replacing the filter, a filtrate (thinner), may be made to flow back through the filter, thereby remove clogging (impurities) in the filter. In this case, cleaning of one of the plurality of filters may be strengthened. Such filter cleaning may be performed sequentially after a certain amount of processing is carried out. In an example shown in **FIG. 8C**, for the purpose of cleaning "A" (filter 39a), only the valve 706 of the flow path between the reservoir of the filtrate and "A" is opened so that the filtrate flows toward "A". In addition, the three-way valve 701 is controlled so that the filtrate flows from "A" to a drain path 750.

As described above, the circulation filtration mechanism has the plurality of filters, and by switching the order of passage of the monomer concentrate through the respective filters, it is possible to avoid only some of the filters from being contaminated.

### [Second exemplary embodiment]

Now, a second exemplary embodiment of the present disclosure will be explained. In the explanation of the second exemplary embodiment, descriptions that overlap with those of the first exemplary embodiment will be omitted, and distinctive features from the first exemplary embodiment will be mainly explained.

In the above-described first exemplary embodiment, the PFAS detoxification system 10 of the processing system 1 has been mainly explained. In the second exemplary embodiment, an example configuration of the semiconductor manufacturing apparatus 100 (substrate processing apparatus) of the processing system 1 will be described in detail. The semiconductor manufacturing apparatus 100 described below does not necessarily have to be used as a set with the PFAS detoxification system 10.

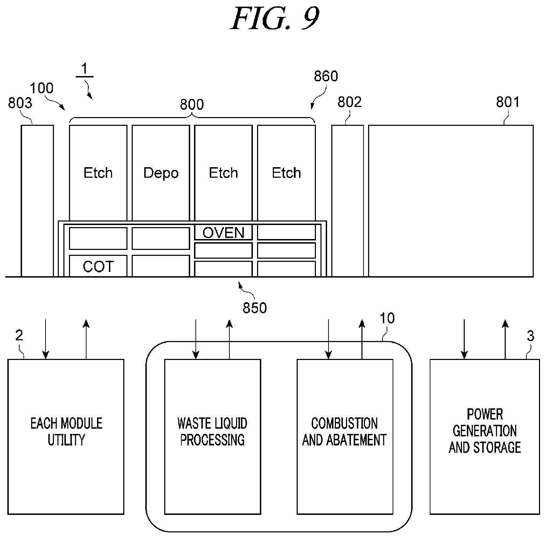

**FIG. 9** is a schematic diagram of the processing system 1 according to the second exemplary embodiment. The processing system 1 includes the semiconductor manufacturing apparatus 100. A waste liquid and an exhaust gas discharged from the semiconductor manufacturing apparatus 100 are processed in the PFAS detoxification system 10, as described above. Further, the semiconductor manufacturing apparatus 100 is operated by receiving electric power and the like from a power generation/storage apparatus 3 and each module utility apparatus 2.

The semiconductor manufacturing apparatus 100 is a system that performs formation of a photosensitive film on a substrate, exposure of the photosensitive film, and development of the photosensitive film. The substrate as a processing target is a semiconductor wafer. The semiconductor manufacturing apparatus 100 is sized to be accommodated in, for example, a clean room. When the clean room has a sufficient height, the semiconductor manufacturing apparatus 100 may be configured as a multi-story structure, for example, a two-story building, by fully utilizing the height of the clean room.

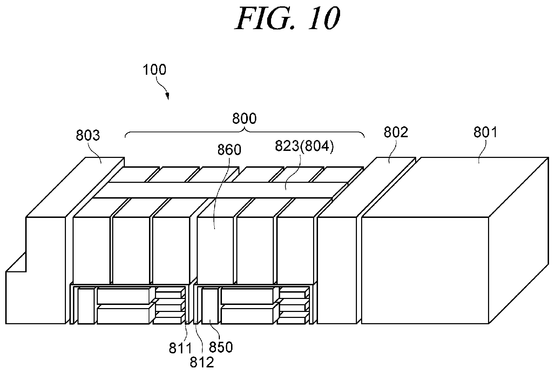

As illustrated in **FIG. 9** and **FIG. 10**, the semiconductor manufacturing apparatus 100 includes a processing block 800, an exposure device 801, an interface block 802 (relay block), and a carrier block 803 (carry-in/carry-out block). In the semiconductor manufacturing apparatus 100, the exposure device 801, for example, is provided at an end, and the interface block 802, the processing block 800, and the carrier block 803 are arranged in this order from the side close to the exposure device 801.

The exposure device 801 performs an exposure processing on a resist film (photosensitive film) coated on the wafer. Specifically, the exposure device 801 irradiates an exposure target portion of the resist film with an energy beam by a method such as EUV exposure or immersion exposure. Further, instead of the exposure device 801, a semiconductor manufacturing device other than the exposure device may be connected. Such a semiconductor manufacturing device may be, by way of example, a device configured to perform a processing such as film formation or cleaning, and the processing method may be a single-substrate processing method in which substrates are processed one by one, or a batch processing method in which a plurality of substrates are processed together.

The carrier block 803 performs a carry-in of the wafer into the processing block 800 and a carry-out of the wafer from the processing block 800. The carrier block 803 is capable of supporting a carrier accommodating a plurality of wafers, and performs the aforementioned carry-in and carry-out of the wafer by carrying the carrier in and out. The carrier block 803 is provided with a plurality of carrier placement tables (not shown) and a wafer transfer device (not shown).

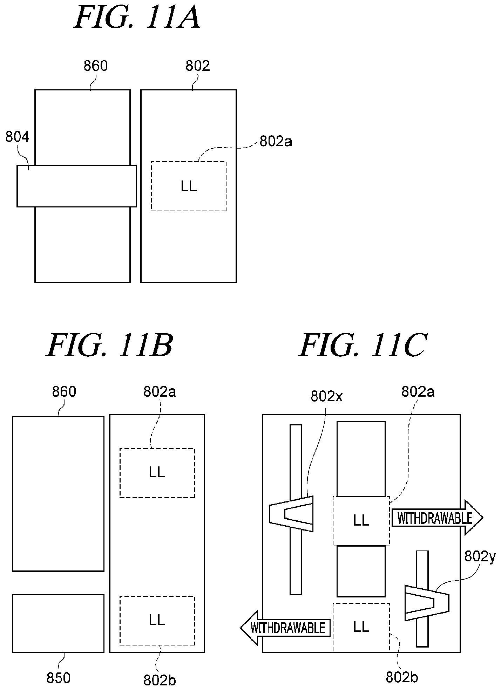

The interface block 802 is connected to the processing block 800 and transfers the wafer to/from the exposure device 801. **FIG. 11A** to **FIG. 11C** are diagrams illustrating the interface block 802. **FIG. 11A**, **FIG. 11B**, and **FIG. 11C** are a plan view, a front view, and a side view of the interface block 802, respectively. As shown in **FIG. 11C**, the interface block 802 has therein transfer devices 802x and 802y including transfer arms, and is connected to the exposure device 801. Further, the interface block 802 has load locks 802a and 802b that function as vacuum environment switching chamber. The load locks 802a and 802b are configured to be withdrawable to enable a wafer transfer in a vacuum environment. Further, the interface block 802 is connected to an atmospheric-system transfer path 821, a vacuum-system transfer path 822, and a bypass transfer path 823, which will be described later.

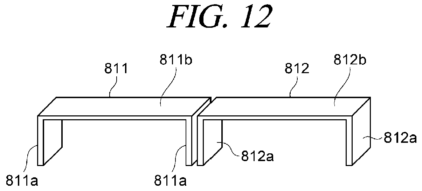

Referring back to **FIG. 10**, the processing block 800 is equipped with an atmospheric-system module 850 (atmospheric-system processing group), a vacuum-system module 860 (vacuum-system processing group), and a transfer path 804. Below, details of the processing block 800 will be described with reference to **FIG. 12** to **FIG. 15B** in addition to **FIG. 10**.

The atmospheric-system module 850 is an atmospheric-system processing group including a plurality of atmospheric-system processing devices. The vacuum-system module 860 is a vacuum-system processing group including a plurality of vacuum-system processing devices and is located directly above the atmospheric-system module 850. The vacuum-system module 860 is positioned directly above the atmospheric-system module 850 via installation stands 811 and 812.

The installation stands 811 and 812 are arranged to cover the atmospheric-system module 850 and support the vacuum-system module 860. As shown in **FIG. 12**, the installation stand 811 has a pair of leg portions 811a, and a support portion 811b provided between the pair of leg portions 811a. The installation stand 812 has a pair of leg portions 812a, and a support portion 812b provided between the pair of leg portions 812a. By way of example, the installation stands 811 and 812 may have the same configuration. The installation stand 811 may cover, for example, the half of the atmospheric-system processing device on a side closer to the carrier block 803 in the atmospheric-system module 850. Additionally, the installation stand 812 may cover, for example, the half of the atmospheric-system processing device on a side closer to the interface block 802 in the atmospheric-system module 850. Furthermore, as long as the installation stands 811 and 812 is capable of supporting the vacuum-system module 860, they do not necessarily cover the entire top surface of the atmosphere system module 850.

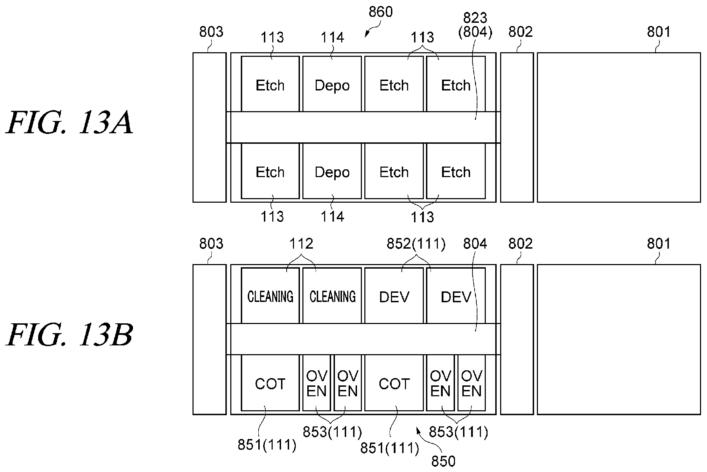

**FIG. 13A** is a schematic diagram of the vacuum-system module 860 viewed from the top, and **FIG. 13B** is a schematic diagram of the atmospheric-system module 850 viewed from the top. In the example shown in **FIG. 13A**, the vacuum-system module 860 includes a plurality of etching devices 113 and a plurality of film forming devices 114. By reducing the heights of the etching devices 113 and the film forming devices 114, it is possible to arrange respective components of the atmospheric-system module 850, which will be described later, in a clearance below. Further, the vacuum-system module 860 may also include a gas-based resist film forming device or a developing device.

Furthermore, in the example shown in **FIG. 13B**, the atmospheric-system module 850 includes a plurality of coating devices 851, a plurality of developing devices 852, a plurality of heat treatment devices 853, and a plurality of cleaning devices 112. For each module, the types and the number of devices included therein are not limited to the aforementioned examples.

Each component of the respective modules described above is configured to be pulled out and inserted, like a drawer of a cabinet, so as to enable maintenance and replacement. Utilities required for each component of the modules may be supplied via, for example, an auto-coupler. This makes it possible to safely attach and detach each component of the modules.

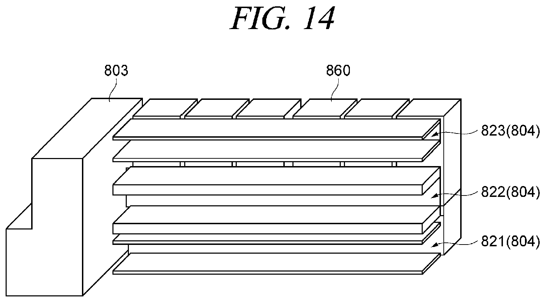

**FIG. 14** is a diagram illustrating each transfer path 804. The semiconductor manufacturing apparatus 100 is equipped with, as the transfer path 804, the atmospheric-system transfer path 821, the vacuum-system transfer path 822, and the bypass transfer path 823.

The atmospheric-system transfer path 821 is a transfer path through which the wafer is delivered to each component of the atmospheric-system module 850 described above. The atmospheric-system transfer path 821 extends between the carrier block 803 and the interface block 802 so as to be connected to both the carrier block 803 and the interface block 802.

The vacuum-system transfer path 822 is a transfer path through which the wafer is delivered to each component of the vacuum-system module 860 described above. The vacuum-system transfer path 822 extends between the carrier block 803 and the interface block 802 so as to be connected to both the carrier block 803 and the interface block 802. The vacuum-system transfer path 822 extends at a height corresponding to the vacuum-system module 860 located above the atmospheric-system module 850, and extends above the atmospheric-system transfer path 821.

The bypass transfer path 823 is a transfer path through which the wafer is delivered between the carrier block 803 and the interface block 802 above the vacuum-system transfer path 822. By using the bypass transfer path 823, the wafer can be transferred more quickly (in a single transfer operation).

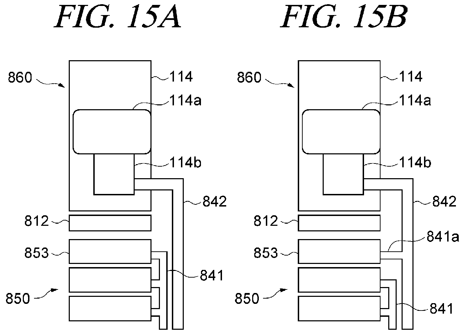

Now, an example of maintenance of an exhaust line that takes advantage of the characteristics of the above-described unitized configuration of the atmospheric-system module 850 and the vacuum-system module 860 will be described. **FIG. 15A** and **FIG. 15B** are diagrams illustrating switching of an exhaust line.

As shown in **FIG. 15A**, it is assumed that a chamber 114a is connected to a reduced-pressure exhaust line 842 via a turbo molecular pump 114b in the film forming device 114 of the vacuum-system module 860, for example. The reduced-pressure exhaust line 842 is a reduced-pressure exhaust line for the film forming device 114, which is a vacuum-system processing device. Further, for example, it is assumed that an atmospheric exhaust line 841 is extended from the plurality of heat treatment devices 853 of the atmospheric-system module 850. Currently, the reduced-pressure exhaust line 842 and the atmospheric exhaust line 841 are assumed to extend close to and parallel with each other.

In this case, as illustrated in **FIG. 15B**, for example, an exhaust line 841a (a part of the exhaust line 841) extending from the heat treatment device 853 can be switchably connected so as to merge with the reduced-pressure exhaust line 842. In this case, a sublimate accumulated in a pipeline of the heat treatment device 853 can be exhausted by a vacuum flowing through the reduced-pressure exhaust line 842, so that the sublimate can be appropriately discharged. This switching of the exhaust line may be performed when semiconductor manufacturing is not being performed or when maintenance is being performed. In this configuration, the exhaust line 841a serves as a reduced-pressure exhaust switching device that enables evacuation of the interior of the atmospheric-system processing device.

In addition, in general, a reduced-pressure exhaust line and an atmospheric exhaust line may be temperature-controlled by being heated to suppress clogging by deposits. In this case, the total amount of energy consumed can be reduced by heating the lines simultaneously rather than heating them individually. That is, by simultaneously heating the above-described reduced-pressure exhaust line 842 and atmospheric exhaust line 841, the total amount of energy consumed may be reduced. In this case, a method of supplying heat in this case may be, for example, waste heat energy from the detoxification device 14, heat generation energy from the cleaning device 112, or electric power energy (power) generated within the apparatus.

Now, effects of the semiconductor manufacturing apparatus 100 according to the present exemplary embodiments will be described.

The semiconductor manufacturing apparatus 100 includes the carrier block 803 for carrying the carrier in and out, the atmospheric-system module 850 including the plurality of atmospheric-system processing devices, and the vacuum-system module 860 including the plurality of vacuum-system processing devices and located directly above the atmospheric-system module 850. The semiconductor manufacturing apparatus 100 further includes the atmospheric-system transfer path 821 configured to transfer wafers to the atmospheric-system processing devices, and the vacuum-system transfer path 822 for delivering the wafers to the vacuum-system processing devices. The atmospheric-system transfer path 821 and the vacuum-system transfer path 822 are connected to the carrier block 803.

In the semiconductor manufacturing apparatus 100 according to the present exemplary embodiments, since the atmospheric-system module 850 and the vacuum-system module 860 are arranged vertically, line routing for the exhaust lines, the utility supply lines, and the like can be consolidated. Further, since the respective dedicated transfer paths are provided in the configuration in which the two modules are arranged vertically, a decrease in transfer efficiency can also be suppressed. According to the semiconductor manufacturing apparatus 100 described above, efficiency in substrate processing can be improved. In addition, since the vacuum-system module 860 is located on the upper side, maintenance can be performed on the vacuum system processing device from various directions.

The semiconductor manufacturing apparatus 100 may also include the installation stands 811 and 812 that are arranged to cover the atmospheric-system module 850 and support the vacuum-system module 860. According to such a configuration, a configuration in which the two modules are arranged vertically can be easily and appropriately realized. In addition, the presence of the installation stands 811 and 812 suppresses application of a load to the atmospheric-system module 850.

The semiconductor manufacturing apparatus 100 may be further equipped with the interface block 802 and the bypass transfer path 823 located above the vacuum-system module 860 and configured to deliver the wafers between the carrier block 803 and the interface block 802. According to this configuration, the wafers can be transferred more rapidly by using the bypass transfer path 823, so that the efficiency in substrate processing can be further improved.

The semiconductor manufacturing apparatus 100 may further include the reduced-pressure exhaust switching device in which the reduced-pressure exhaust line 842 of the vacuum-system processing device is connected to the atmospheric exhaust line 841 of the atmospheric-system processing device, and the interior of the atmospheric-system processing device can be evacuated via the atmospheric exhaust line 841. According to this configuration, the sublimate accumulated in the atmospheric exhaust line 841 can be exhausted by the vacuum flowing through the reduced-pressure exhaust line 842, so that the sublimate can be appropriately discharged.

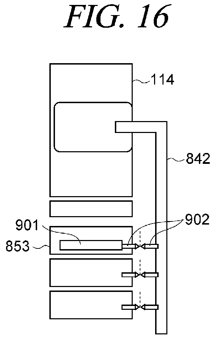

So far, the exemplary embodiments have been described. However, the present disclosure is not limited thereto. By way of example, the configuration of the atmospheric-system module 850 may be adopted in such a way that the temperature thereof is controlled by an exhaust gas or temperature-controlled water from the vacuum-system module 860. **FIG. 16** is a diagram illustrating an exhaust line according to this modification example. It is assumed that, in the vacuum-system module, the reduced-pressure exhaust line 842 of the filming forming device 114, which is a vacuum-system processing device, functions as a waste heat line. In addition, it is assumed that a heat conduction member 901 capable of conducting heat is connected to the heat treatment device 853, which is an atmospheric-system processing device. In this case, by providing a heat conduction mechanism 902 connecting the reduced-pressure exhaust line 842 serving as a waste heat line and the heat conduction member 901 to each other to transfer heat to the heat treatment device 853, so that temperature control in the atmospheric-system module can be appropriately carried out by using waste heat from the vacuum-system module. The heat conduction mechanism 902 may be always connected, or a connection state thereof may be switched based on a signal from a controller (not shown). Further, the reduced-pressure exhaust line 842 may be replaced with a pipeline through which temperature-controlled water flows. In this case, preliminary temperature control of the heat treatment device 853 may be performed, and the temperature-controlled water is used up to about 60°C. Then, the heat treatment device 853 may be heated further up to a target temperature by electric power.

Furthermore, the configuration in which the vacuum-system module is arranged at the top and the atmospheric-system module at the bottom has the following advantages, for example, as compared to a configuration in which they are not unitized.

### · Footprint reduction

Reduction of footprint is achieved by vertically stacking the vacuum system and the atmospheric system, which have been conventionally installed as separate apparatuses.

### · Q-time control (inter-layer process optimization)

When multiple devices are provided independently, a substrate is transferred between these devices by OHT. In contrast, by integrating a vacuum-system device and an atmospheric-system device as a single in-line apparatus sharing L/P as in the configuration of the present exemplary embodiments, transition to a subsequent process can be achieved more quickly than through OHT transfer while stabilizing and shortening the time required between processes. The configuration also provides advantages as a total solution for pattern control. Optimization is typically performed for each individual device. However, as devices are connected to each other as in the configuration of the present exemplary embodiments, it is easy to comprehensively manage these processing conditions, and the like, making it easy to provide optimal processing conditions or results as a series of total processes.

### · Energy saving and waste control

Since the modules in the vacuum system and the atmospheric system are stacked vertically, energy saving can be achieved by using the configuration of one device among the plurality of vertically arranged devices as described herein to control and adjust the environment of the other device. With respect to waste control, since the vacuum-system module and the atmospheric-system module are spatially consolidated by being vertically stacked, a waste exhaust section can also be consolidated easily. Since the processing devices are consolidated, the overall system can be readily provided in a compact size. In addition, management of the amount of waste generated through many processes performed on substrates in the vacuum-system module and the atmospheric-system module as well as management of waste disposal conditions can be performed by a single waste processing system.
- Flexible transfer control (facilitation of multiple transfers to the same module and flexible transfer between upper and lower levels), and flexible module arrangement (a configuration including only a COT module, only a cleaning module, or only an etching module)

Substrates can be distributed and transferred to each of the vacuum system and the atmospheric system, and can be processed in the same module multiple times by being moved back and forth between the upper and lower levels. When the upper and lower layers are connected on both the CSB side and the opposite side thereof, it is possible to suppress stagnation of the substrates through a transfer path that circulates between the upper and lower layers, so that smooth processing may be realized. Further, a plurality of types of processing devices need not necessarily be provided in each of the vacuum system layer and the atmospheric system layer, and only a single type of device may be provided therein. Accordingly, a high degree of freedom in device layout may be achieved.

### · Other benefits

In semiconductor production, there are a case in which the same product is mass-produced and a case in which a wide variety of products are produced in small quantities. In the configuration of the present exemplary embodiments, since the various processing modules are provided and a combination of the modules to be used can be selected according to the type of a product to be manufactured, the configuration is advantageous for muti-type and low-quantity production. Even in the mass production, different types of devices may be used, and parallel processing may be performed by a plurality of devices even when the devices are of the same type. In such cases, stable production cannot be achieved unless variations among the devices are taken into consideration. In the configuration of the present exemplary embodiments, however, since processes are stabilized within a compact and closed combination of devices, efficient production is enabled.

Finally, various exemplary embodiments included in the present disclosure are described in [E1] to [E14] below.
[E1] A processing apparatus that processes a waste liquid discharged from a semiconductor manufacturing apparatus, the processing apparatus including:
   a first filter separating the waste liquid into a first solution including a high-molecular-weight component at a concentration equal to or higher than a preset level, and a second solution not including the high-molecular-weight component at the concentration equal to or higher than the preset level and including a low-molecular-weight component at a concentration equal to or higher than a preset level; and
   a low-molecular-weight component processing module performing a processing of increasing the concentration of the low-molecular-weight component in the second solution separated by the first filter.
[E2] The processing apparatus described in [E1],
   wherein the low-molecular-weight component processing module includes a circulation filtration mechanism circulating the second solution to filter the low-molecular-weight component, and a purification mechanism removing PFAS from a filtrate that has passed through the circulation filtration mechanism.
[E3] The processing apparatus described in [E2],
   wherein the circulation filtration mechanism includes multiple second filters, and a passage order switching mechanism switching an order of serial passage of the second solution through the multiple second filters.
[E4] The processing apparatus described in any one of [E1] to [E3],
   wherein the first filter and the low-molecular-weight component processing module are individually provided for respective types of solvents contained in the waste liquid.
[E5] The processing apparatus described in any one of [E1] to [E4], further including:
   a positive developing waste liquid processing module separating a TMAH waste liquid into a PFAS-concentrated developing liquid and a PFAS-free developing liquid;
   a developing waste liquid filter removing a polymer from the TMAH waste liquid; and
   a cleaning liquid chamber for a developing liquid filter, which stores a liquid passed by causing the PFAS-free developing liquid to flow back from a secondary side of the developing waste liquid filter.
[E6] The processing apparatus described in any one of [E1] to [E5],
   wherein the low-molecular-weight component processing module further includes a reservoir storing the second solution, and a PFAS capture section having an inlet located on a downstream side of a flow of the second solution along a liquid surface of the reservoir.
[E7] The processing apparatus described in [E6],
   wherein the low-molecular-weight component processing module further includes a microbubble generator generating microbubbles in the second solution of the reservoir.
[E8] A processing method of processing a waste liquid discharged from a semiconductor manufacturing apparatus, the processing method including:
   separating the waste liquid into a first solution including a high-molecular-weight component at a concentration equal to or higher than a preset level, and a second solution not including the high-molecular-weight component at the concentration equal to or higher than the preset level and including a low-molecular-weight component at a concentration equal to or higher than a preset level; and
   performing a processing of increasing the concentration of the low-molecular-weight component in the second solution separated in the separating of the waste liquid.
[E9] A substrate processing apparatus, including:
   a carry-in/carry-out block performing a carry-in/carry-out of a carrier accommodating multiple substrates;
   an atmospheric-system processing group including multiple atmospheric-system processing devices;
   a vacuum-system processing group including multiple vacuum-system processing devices and positioned directly above the atmospheric-system processing group;
   an atmospheric-system transfer path through which the substrate is delivered to the atmospheric-system processing device; and
   a vacuum-system transfer path through which the substrate is delivered to the vacuum-system processing device,
   wherein the atmospheric-system transfer path and the vacuum-system transfer path are connected to the carry-in/carry-out block.
[E10] The substrate processing apparatus described in [E9], further including:
   an installation stand arranged to cover the atmospheric-system processing group and support the vacuum-system processing group.
[E11] The substrate processing apparatus described in [E9] or [E10], further including:
   a relay block connected to the atmospheric-system transfer path and the vacuum-system transfer path; and
   a bypass transfer path through which the substrate is delivered between the carry-in/carry-out block and the relay block above the vacuum-system processing group.
[E12] The substrate processing apparatus described in any one of [E9] to [E11], further including:
   a reduced-pressure exhaust switching device in which a reduced-pressure exhaust line of the vacuum-system processing device is connected to an atmospheric exhaust line of the atmospheric-system processing device, and an interior of the atmospheric-system processing device is evacuated via the atmospheric exhaust line.
[E13] The substrate processing apparatus described in any one of [E9] to [E12], further including:
   a waste heat line of the vacuum-system processing device;
   a heat conduction member connected to the atmospheric-system processing device and allowed to transfer heat; and
   a heat conduction mechanism connecting the waste heat line and the heat conduction member to transfer heat to the atmospheric-system processing device.
[E14] A processing system, including:
   a substrate processing apparatus described in any one of [E9] to [E13]; and
   a single waste processing device processing a waste discharged from the atmospheric-system processing device and a waste discharged from the vacuum-system processing device.

### EXPLANATION OF CODES

10: PFAS detoxification system
11: Concentrator
12: Sulfuric acid processing vessel
13: Cooler
14:Detoxification device
100: Semiconductor manufacturing apparatus
111: Lithography device
112: Cleaning device
113: Etching device
114: Film forming device

## Claims

1. A processing apparatus that processes a waste liquid discharged from a semiconductor manufacturing apparatus, the processing apparatus comprising:
a first filter separating the waste liquid into a first solution including a high-molecular-weight component at a concentration equal to or higher than a preset level, and a second solution not including the high-molecular-weight component at the concentration equal to or higher than the preset level and including a low-molecular-weight component at a concentration equal to or higher than a preset level; and
a low-molecular-weight component processing module performing a processing of increasing the concentration of the low-molecular-weight component in the second solution separated by the first filter.

2. The processing apparatus of Claim 1,
wherein the low-molecular-weight component processing module comprises a circulation filtration mechanism circulating the second solution to filter the low-molecular-weight component, and a purification mechanism removing PFAS from a filtrate that has passed through the circulation filtration mechanism.

3. The processing apparatus of Claim 2,
wherein the circulation filtration mechanism comprises multiple second filters, and a passage order switching mechanism switching an order of serial passage of the second solution through the multiple second filters.

4. The processing apparatus of Claim 1,
wherein the first filter and the low-molecular-weight component processing module are individually provided for respective types of solvents contained in the waste liquid.

5. The processing apparatus of Claim 1, further comprising:
a positive developing waste liquid processing module separating a TMAH waste liquid into a PFAS-concentrated developing liquid and a PFAS-free developing liquid;
a developing waste liquid filter removing a polymer from the TMAH waste liquid; and
a cleaning liquid chamber for a developing liquid filter, which stores a liquid passed by causing the PFAS-free developing liquid to flow back from a secondary side of the developing waste liquid filter.

6. The processing apparatus of Claim 1,
wherein the low-molecular-weight component processing module further comprises a reservoir storing the second solution, and a PFAS capture section having an inlet located on a downstream side of a flow of the second solution along a liquid surface of the reservoir.

7. The processing apparatus of Claim 6,
wherein the low-molecular-weight component processing module further comprises a microbubble generator generating microbubbles in the second solution of the reservoir.

8. A processing method of processing a waste liquid discharged from a semiconductor manufacturing apparatus, the processing method comprising:
separating the waste liquid into a first solution including a high-molecular-weight component at a concentration equal to or higher than a preset level, and a second solution not including the high-molecular-weight component at the concentration equal to or higher than the preset level and including a low-molecular-weight component at a concentration equal to or higher than a preset level; and
performing a processing of increasing the concentration of the low-molecular-weight component in the second solution separated in the separating of the waste liquid.
